# FASCICULE DE BREVET EUROPEEN

(11) **EP 4 229 686 B1**
(45) Date de publication et mention de la délivrance du brevet: **14.10.2026**
(21) Numéro de dépôt: 21794604.5
(22) Date de dépôt: 27.09.2021
(51) Int. Cl.: H10N 30/072, H10N 30/20, H10N 30/00

(54) **STRUCTURE COMPOSITE POUR APPLICATIONS MEMS, COMPRENANT UNE COUCHE DÉFORMABLE ET UNE COUCHE PIÉZOÉLECTRIQUE, ET PROCÉDÉ DE FABRICATION ASSOCIÉ**
VERBUNDSTRUKTUR FÜR MEMS-ANWENDUNGEN MIT EINER VERFORMBAREN SCHICHT UND EINER PIEZOELEKTRISCHEN SCHICHT UND ZUGEHÖRIGES HERSTELLUNGSVERFAHREN
COMPOSITE STRUCTURE FOR MEMS APPLICATIONS, COMPRISING A DEFORMABLE LAYER AND A PIEZOELECTRIC LAYER, AND ASSOCIATED MANUFACTURING PROCESS

(30) Priorité: 16.10.2020 FR 2010659
(43) Date de publication de la demande: 23.08.2023
(73) Titulaire: SOITEC, 38190 Bernin (FR)
(72) Inventeur: GHYSELEN, Bruno, 38190 Bernin (FR); DARRAS, François-Xavier, 38190 Bernin (FR)
(74) Mandataire: IP Trust
(86) Numéro de dépôt international: PCT/FR2021/051662
(87) Numéro de publication internationale: WO 2022/079366

(56) Documents cités:
- WO-A1-2010/114602
- WO-A1-2020/128244
- US-A1- 2008 296 529

## Description

### DOMAINE DE L'INVENTION

La présente invention concerne le domaine de la microélectronique et des microsystèmes. Elle concerne en particulier une structure composite comprenant une couche piézoélectrique et une couche semi-conductrice monocristalline à propriétés élastiques, susceptible de se déformer au-dessus d'au moins une cavité. L'invention concerne également un procédé de fabrication de la structure composite.

### ARRIERE PLAN TECHNOLOGIQUE DE L'INVENTION

Dans le domaine des MEMS (« Microelectromechanical systems » selon la terminologie anglo-saxonne) et des actionneurs, il est habituel de trouver des substrats et des composants embarquant une couche mince en matériau piézoélectrique disposée sur une couche déformable ; cette dernière présente des propriétés élastiques lui permettant de se déplacer ou de se déformer sous la forme d'une membrane mobile au-dessus d'une cavité. Rappelons que le terme membrane est employé ici au sens large, et englobe une membrane étanche ou trouée, une poutre ou toute autre forme de membrane susceptible de fléchir et/ou se déformer. La couche déformable confère la tenue mécanique à la membrane tandis que la couche piézoélectrique provoque ou détecte une déformation de la membrane. Ce concept s'étend également au domaine des filtres à ondes acoustiques.

Le document US2008/296529 propose par exemple un film fin piézoélectrique (1) composé d'un film de nitrure d'aluminium (3) dopé au scandium et disposé sur un substrat (2) en silicium, destiné à être utilisé dans un résonateur, un actionneur ou un capteur piézoélectrique.

Les matériaux piézoélectriques en films minces, notamment le PZT (Titano-Zirconate de Plomb), sont souvent sensibles à un environnement extérieur agressif et donc susceptibles de se dégrader lorsqu'ils y sont longuement exposés. Cela peut par exemple être le cas dans des capteurs ou actuateurs tels que les microphones, les haut-parleurs ou les transducteurs ultrasoniques micro-usinés piézoélectriques (pMUT). Il est donc nécessaire de prévoir, dans le procédé de fabrication, une étape additionnelle de dépôt d'un film de protection, sur la couche piézoélectrique, pour l'isoler de l'environnement extérieur, mais sans affecter ses performances. C'est notamment ce que propose le document WO2010/114602 avec la formation d'une couche ou d'un capot d'encapsulation (112,210) au-dessus de la structure piézoélectrique (102,202).

Par ailleurs, et si l'on reprend l'exemple de la couche piézoélectrique en PZT, ce matériau, simple à déposer, requiert une étape de recristallisation à des températures de l'ordre de 700°C pour atteindre un bon niveau de qualité. Pour certaines applications, le substrat comportant la couche déformable sur laquelle la couche piézoélectrique doit être déposée, peut s'avérer incompatible avec de telles températures : par exemple, s'il comprend un support en verre ou en plastique, ou encore s'il embarque des composants tels que des transistors.

Le document WO2020/128244 concerne un procédé de fabrication d'une structure à cavités enterrées, pour des dispositifs MEMS.

### OBJET DE L'INVENTION

La présente invention concerne une solution alternative à celles de l'état de la technique, et vise à remédier à tout ou partie des inconvénients précités. Elle concerne en particulier une structure composite comprenant une couche piézoélectrique et une couche semi-conductrice monocristalline aux propriétés élastiques, apte à se déformer au-dessus d'au moins une cavité. L'invention concerne également un procédé de fabrication de la structure composite.

### BREVE DESCRIPTION DE L'INVENTION

L'invention concerne une structure composite comprenant :
- un substrat receveur comportant au moins une cavité définie dans ledit substrat et dépourvue de matériau solide ou remplie d'un matériau solide sacrificiel,
- une couche semi-conductrice monocristalline disposée sur le substrat receveur, ladite couche présentant une surface libre sur toute l'étendue de la structure et une épaisseur comprise entre 0,1 micron (1 micron = 1 µm) et 100 microns,
- une couche piézoélectrique solidaire de la couche semi-conductrice monocristalline et disposée entre cette dernière et le substrat receveur.

Dans la structure composite selon l'invention, au moins une portion de la couche semi-conductrice monocristalline est destinée à former une membrane mobile au-dessus de la cavité, lorsque cette dernière est dépourvue de matériau solide ou après que le matériau solide sacrificiel ait été éliminé, et la couche piézoélectrique est destinée à provoquer ou détecter la déformation de ladite membrane.

Selon d'autres caractéristiques avantageuses et non limitatives de l'invention, prises seules ou selon toute combinaison techniquement réalisable :
- la couche piézoélectrique comprend un matériau choisi parmi le niobate de lithium (LiNbO3), le tantalate de lithium (LiTaO3), le niobate de potassium-sodium (KxNa1-xNbO3 ou KNN), le titanate de barium (BaTiO3), le quartz, le titano-zirconate de plomb (PZT), un composé de niobate de plomb-magnésium et de titanate de plomb (PMN-PT), l'oxide de zinc (ZnO), le nitrure d'aluminium (AlN) ou le nitrure d'aluminium et de scandium (AlScN) ;
- la couche piézoélectrique présente une épaisseur inférieure à 10 microns, préférentiellement inférieure à 5 microns ;
- la couche semi-conductrice monocristalline est en silicium ou en carbure de silicium ;
- la couche piézoélectrique est disposée uniquement en vis-à-vis de la -au moins une- cavité du substrat receveur ;
- la couche piézoélectrique est disposée en vis-à-vis de la - au moins une- cavité du substrat receveur et est solidaire du substrat receveur en-dehors de la -au moins une- cavité.

L'invention concerne également un dispositif basé sur une membrane mobile au-dessus d'une cavité, formé à partir de la structure composite précitée, comprenant au moins deux électrodes en contact avec la couche piézoélectrique, et dans lequel :
- la cavité est dépourvue de matériau solide,
- et au moins une portion de la couche semi-conductrice monocristalline forme la membrane mobile au-dessus de la cavité.

L'invention concerne enfin un procédé de fabrication d'une structure composite, comprenant les étapes suivantes :
a) la fourniture d'un substrat donneur comprenant une couche semi-conductrice monocristalline, délimitée entre une face avant du substrat donneur et un plan fragile enterré dans ledit substrat donneur, ladite couche présentant une épaisseur comprise entre 0,1 micron et 100 microns,
b) la fourniture d'un substrat receveur comportant au moins une cavité définie dans ledit substrat et débouchant au niveau d'une face avant dudit substrat receveur, la cavité étant dépourvue de matériau solide ou remplie d'un matériau solide sacrificiel,
c) la formation d'une couche piézoélectrique de manière à ce qu'elle soit disposée sur la face avant du substrat donneur et/ou sur la face avant du substrat receveur,
d) l'assemblage du substrat donneur et du substrat receveur au niveau de leurs faces avant respectives,
e) la séparation, le long du plan fragile enterré, entre la couche semi-conductrice monocristalline et le reste du substrat donneur, pour former la structure composite comprenant la couche semi-conductrice monocristalline, la couche piézoélectrique et le substrat receveur.

Selon d'autres caractéristiques avantageuses et non limitatives de l'invention, prises seules ou selon toute combinaison techniquement réalisable :
- le plan fragile enterré est formé par implantation d'espèces légères dans le substrat donneur, et la séparation le long dudit plan fragile enterré est obtenue par un traitement thermique et/ou par l'application d'une contrainte mécanique ;
- le plan fragile enterré est formé par une interface présentant une énergie de collage inférieure à 0,7 J/m² ;
- le procédé de fabrication comprend une étape de formation d'électrodes métalliques avant et/ou après l'étape c), pour que lesdites électrodes soient en contact avec la couche piézoélectrique ;
- l'étape c) comprend, lorsque la couche piézoélectrique est formée sur la face avant du substrat donneur, une gravure locale de ladite couche piézoélectrique, de manière à conserver la couche piézoélectrique uniquement en vis-à-vis de la -au moins une- cavité à l'issue de l'étape d) d'assemblage.

### BREVE DESCRIPTION DES FIGURES

D'autres caractéristiques et avantages de l'invention ressortiront de la description détaillée de l'invention qui va suivre en référence aux figures annexées sur lesquelles :
[Fig. 1a]
[Fig. 1b]
[Fig. 1c] Les figures 1a, 1b et 1c présentent des structures composites conformes à l'invention ;
[Fig. 2] La figure 2 présente un dispositif basé sur une membrane mobile au-dessus d'une cavité, formé à partir d'une structure composite conforme à l'invention ;
[Fig. 3a]
[Fig. 3b]
[Fig. 3c]
[Fig. 3d]
[Fig. 3e]
[Fig. 3f]

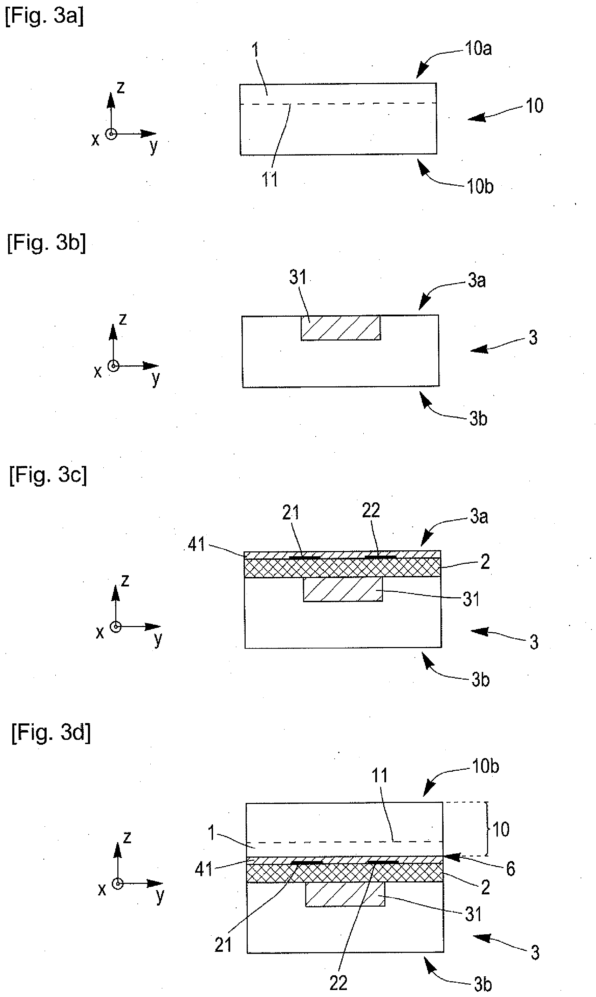

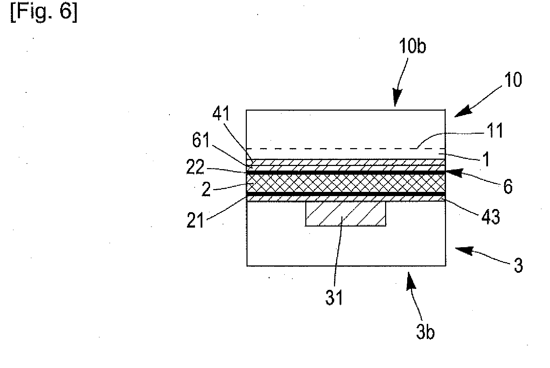

[Fig. 6] Les figures 3a à 3f et la figure 6 présentent des étapes d'un procédé de fabrication de la structure composite, conforme à la présente invention ;
[Fig. 4a]

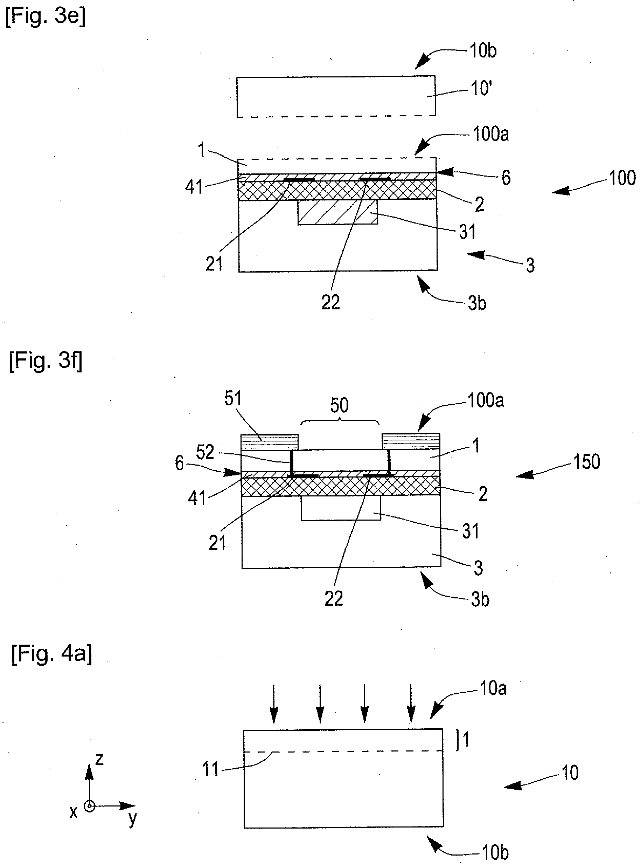

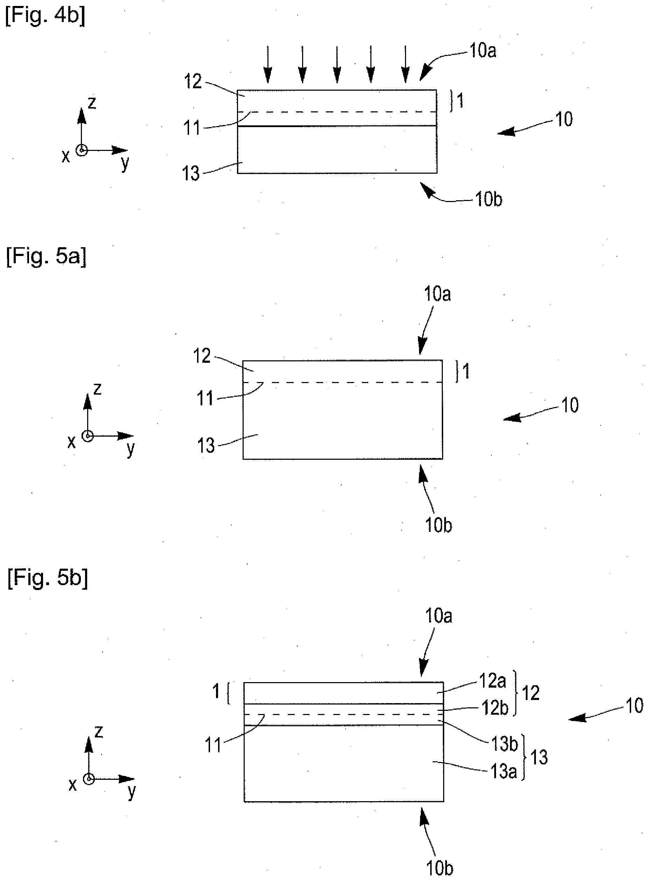

[Fig. 4b] Les figures 4a, 4b présentent des substrats donneurs selon une première variante de mise en œuvre du procédé de fabrication conforme à l'invention ;
[Fig. 5a]
[Fig. 5b] Les figures 5a,5b présentent des substrats donneurs selon une deuxième variante de mise en œuvre du procédé de fabrication conforme à l'invention.

Les mêmes références sur les figures peuvent être utilisées pour des éléments de même type. Les figures sont des représentations schématiques qui, dans un objectif de lisibilité, ne sont pas à l'échelle. En particulier, les épaisseurs des couches selon l'axe z ne sont pas à l'échelle par rapport aux dimensions latérales selon les axes x et y ; et les épaisseurs relatives des couches entre elles ne sont pas nécessairement respectées sur les figures.

### DESCRIPTION DETAILLEE DE L'INVENTION

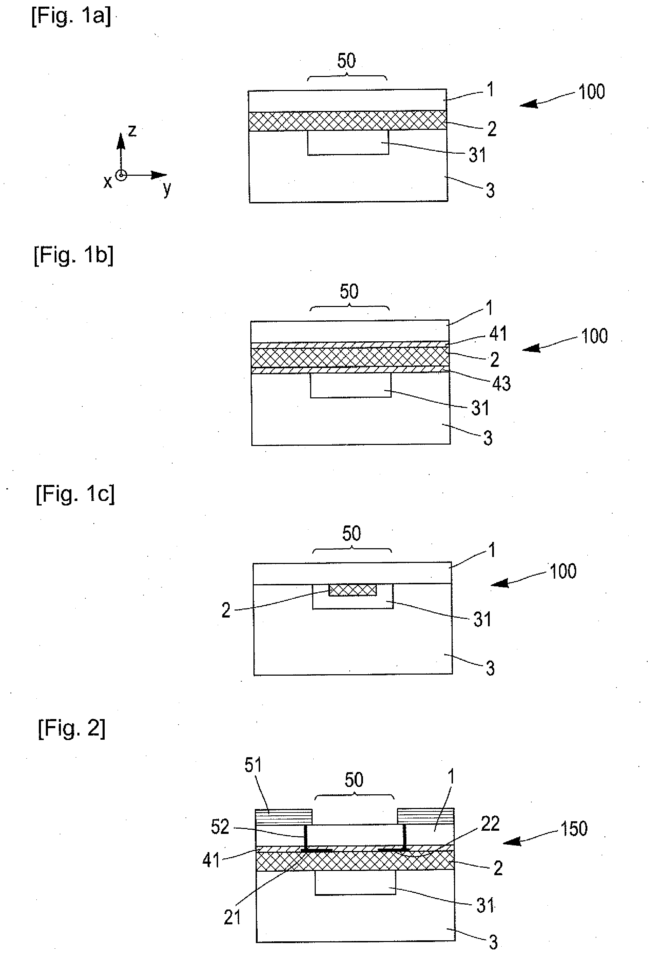

La structure composite 100 selon la présente invention comprend un substrat receveur 3 qui comporte au moins une cavité 31 dépourvue de matériau solide ou remplie d'un matériau solide sacrificiel (figures 1a, 1b). Le substrat receveur 3 a avantageusement la forme d'une plaquette, de diamètre supérieur à 100mm, par exemple 150mm, 200mm ou 300mm. Son épaisseur est typiquement comprise entre 200 et 900 microns. Il est préférentiellement composé de matériaux à faible coût (silicium, verre, plastique) quand sa fonction est essentiellement mécanique, ou formé à partir de substrats fonctionnalisés (incluant des composants tels que des transistors, par exemple) quand des dispositifs intégrés plus complexes sont visés sur la structure composite 100.

La structure composite 100 comprend également une couche semi-conductrice monocristalline 1 disposée sur la couche piézoélectrique 2. Cette couche 1 présente des propriétés mécaniques lui permettant de se déformer au-dessus d'une cavité, et ce de manière très contrôlée. Le caractère monocristallin de la couche 1 garantit la stabilité et la reproductibilité de ses propriétés, contrairement par exemple au cas d'un matériau poly-cristallin pour lequel les propriétés mécaniques sont fortement dépendantes des conditions de dépôt (taille et forme des grains, nature des joints de grains, contraintes, etc). Dans le cas d'un matériau monocristallin, les propriétés mécaniques de la couche 1 peuvent ainsi être simplement contrôlées, simulées et anticipées par la simple connaissance de quelques paramètres fondamentaux comme le module d'élasticité (module de Young) ou encore le coefficient de Poisson. On appellera cette couche semi-conductrice 1, couche monocristalline 1 ou couche élastique 1, de manière équivalente, dans la suite de la description.

Préférentiellement, mais sans que cela soit limitatif, elle est formée en silicium ou en carbure de silicium. Elle présente avantageusement une épaisseur comprise entre 0,1 micron et 100 microns.

La structure composite 100 comprend aussi une couche piézoélectrique 2 solidaire de la couche semi-conductrice monocristalline 1 et disposée entre cette dernière et le substrat receveur 3.

Selon une première variante illustrée sur la figure 1a, la couche piézoélectrique 2 est en contact (direct ou indirect c'est-à-dire via une autre couche) avec la couche semi-conductrice monocristalline 1 par l'une de ses faces et en contact (direct ou indirect) avec le substrat receveur 3 par son autre face.

Si le substrat receveur 3 est de nature semi-conductrice ou conductrice, on pourra prévoir une couche isolante intermédiaire 43 entre le substrat 3 et la couche piézoélectrique 2 (figure 1b). Si le substrat receveur 3 est de nature isolante, cette couche isolante 43 ne sera pas nécessaire pour des considérations électriques mais pourra être utile pour améliorer l'adhérence entre les couches et/ou la qualité structurelle de la couche piézoélectrique 2.

Selon une deuxième variante illustrée sur la figure 1c, la couche piézoélectrique 2 est localement en contact (direct ou indirect c'est-à-dire via une autre couche) avec la couche semi-conductrice monocristalline 1 par l'une de ses faces, son autre face se trouvant en vis-à-vis de la (au moins une) cavité 31 du substrat receveur 3.

Dans l'une ou l'autre des variantes énoncées, on pourra prévoir une couche isolante intermédiaire 41 entre la couche élastique 1 et la couche piézoélectrique 2 (figure 1b).

Les couches isolantes intermédiaires 41,43 sont typiquement composées d'oxyde de silicium (SiO2) ou de nitrure de silicium (SiN).

La couche piézoélectrique 2 peut comprendre un matériau choisi parmi le niobate de lithium (LiNbO3), le tantalate de lithium (LiTaO3), le niobate de potassium-sodium (KₓNa₁₋ₓNbO₃ ou KNN), le titanate de barium (BaTiO3), le quartz, le titano-zirconate de plomb (PZT), un composé de niobate de plomb-magnésium et de titanate de plomb (PMN-PT) à proportions variables (par exemple 70/30 ou 90/10) selon les propriétés recherchées, l'oxide de zinc (ZnO), le nitrure d'aluminium (AlN), le nitrure d'aluminium et de scandium (AlScN), etc. L'épaisseur de la couche piézoélectrique 2 peut varier typiquement entre 0,5 micron et 10 microns, préférentiellement entre 1 micron et 5 microns.

Dans la structure composite 100, la couche piézoélectrique 2 est protégée par la couche élastique 1. Dans certains cas, on pourra ainsi s'affranchir d'une couche additionnelle de protection pour protéger la couche piézoélectrique 2 vis-à-vis de l'environnement extérieur et/ou pour confiner la couche piézoélectrique 2 (les matériaux piézoélectriques à base de plomb doivent être enfouis pour être compatibles avec certaines applications). Alternativement, on pourra prévoir une couche de protection, mais celle-ci pourra alors être simplifiée par rapport aux couches standard de l'état de la technique. Selon encore une autre option, on peut souhaiter conserver une couche de protection standard, mais son efficacité s'en retrouvera renforcée du fait de la protection déjà assurée par l'invention.

La structure composite 1 procure une membrane 50 comprenant au moins une portion de la couche monocristalline 1, et surplombant une cavité 31 aménagée dans le substrat receveur 3. Comme énoncé en introduction, la couche piézoélectrique 2 est prévue pour provoquer ou détecter la déformation de ladite membrane 50 au-dessus de la cavité 31.

Un dispositif 150 basé sur une membrane 50 mobile au-dessus d'une cavité 31 peut ainsi être formé à partir de la structure composite 100 précitée (figure 2). Le dispositif 150 comprend au moins deux électrodes 21,22 en contact avec la couche piézoélectrique 2 ; elles sont destinées à envoyer et/ou récupérer un signal électrique associé à la déformation de la membrane 50. Les électrodes 21,21 peuvent notamment être formées en platine, en aluminium, en titane ou encore en molybdène. Dans l'exemple de la figure 2, les électrodes 21,22 sont disposées contre la face de la couche piézoélectrique 2 qui est en vis-à-vis de la couche élastique 1. Alternativement, elles peuvent être disposées sur l'autre face (en vis-à-vis du substrat receveur 3), ou respectivement sur l'une et l'autre des faces de la couche piézoélectrique 2. Lorsqu'elles sont disposées sur une même face de la couche piézoélectrique 2, les électrodes 21,22, prennent avantageusement la forme d'un peigne interdigité. Dans tous les cas, pour isoler les électrodes 21,22 de la couche monocristalline 1 et/ou du substrat receveur 3, une (ou des) couche(s) isolante(s) 41,43 est(sont) prévue(s) en position intermédiaire.

Dans le dispositif 150, la (au moins une) cavité 31 est dépourvue de matériau solide, de manière à autoriser la déformation de la membrane 50. Selon l'application recherchée, la cavité 31 peut alors être ouverte ou fermée, la fermeture pouvant aller jusqu'à un scellement étanche. Dans ce dernier cas, une atmosphère contrôlée peut être confinée dans ladite cavité 31. L'atmosphère contrôlée pourra correspondre à un vide plus ou moins poussé (par exemple, entre 10⁻² mbar et la pression atmosphérique), et/ou à un mélange gazeux particulier (par exemple atmosphère neutre, azote ou argon, air ambiant).

Dans le cas d'une cavité ouverte, l'ouverture peut prendre plusieurs formes. Il peut s'agir d'une ouverture par la face arrière, à travers le substrat receveur 3. Il peut s'agir encore d'une ouverture sous la forme d'un canal latéral aménagé dans le substrat receveur 3. L'ouverture peut également se faire par un ou des orifice(s) traversant la membrane 50. Une poutre flexible encastrée est un exemple de conception généralement associé à une structure composite de type cavité ouverte.

Au moins une portion de la couche élastique 1 forme la membrane 50 mobile au-dessus de la cavité 31. Par ailleurs, des éléments fonctionnels 51 peuvent être élaborés sur ou dans la couche élastique 1, pour interagir avec les électrodes de la couche piézoélectrique 2 et/ou avec la membrane en général. Optionnellement, les éléments fonctionnels 51 peuvent comprendre des transistors, des diodes ou autres composants microélectroniques.

Comme la couche piézoélectrique 2 est enfouie sous la couche élastique 1, il peut apparaitre opportun de créer des vias conducteurs 52, s'étendant à travers ladite couche 1 et à travers la couche isolante intermédiaire 41 si elle est présente, qui permettent de raccorder électriquement les électrodes 21,22 par la face avant de la structure composite 100. Alternativement, le raccordement électrique peut se faire par la face arrière de la structure composite, grâce à des vias conducteurs traversant tout ou partie du substrat receveur 3, et la couche isolante intermédiaire 43 si elle présente.

L'invention concerne également un procédé de fabrication de la structure composite 100 précitée. Le procédé comprend en premier lieu la fourniture d'un substrat donneur 10 présentant une face avant 10a et une face arrière 10b. Le substrat donneur 10 a avantageusement la forme d'une plaquette, de diamètre supérieur à 100mm, par exemple 150mm, 200mm ou 300mm. Son épaisseur est typiquement comprise entre 200 et 900 microns.

Le substrat donneur 10 comprend une couche semi-conductrice monocristalline 1, délimitée entre sa face avant 10a et un plan fragile enterré 11 formé dans ledit substrat donneur 10 (figure 3a).

Selon un premier mode de réalisation, le plan fragile enterré 11 est formé par implantation d'espèces légères dans le substrat donneur 10, sur le principe du procédé Smart Cut^{™}, particulièrement adapté pour le transfert de couches minces monocristallines (figure 4a). Le substrat donneur 10 peut être un substrat monocristallin vierge, présentant les propriétés élastiques visées pour la couche monocristalline 1. Il pourra par exemple s'agir d'une plaquette en silicium monocristallin. Alternativement, il peut présenter du côté de sa face avant 10a, une couche donneuse 12 dans laquelle pourra être délimitée la couche élastique 1 (figure 4b). La couche donneuse 12 peut être disposée sur un support quelconque 13 adapté pour conférer la tenue mécanique du substrat donneur 10, étant entendu qu'il devra être compatible avec la suite des étapes du procédé. Il peut par exemple s'agir d'une couche donneuse 12 en silicium élaborée par épitaxie sur une plaquette support 13 en silicium monocristallin de moindre qualité.

Ce premier mode de réalisation est particulièrement adapté aux couches monocristallines d'épaisseur inférieures à 2 microns.

Selon un deuxième mode de réalisation, le plan fragile enterré 11 est formé par une interface présentant une énergie de collage inférieure typiquement à 0,7 J/m², de manière à autoriser une séparation, ultérieurement dans le procédé, au niveau de ladite interface. Le substrat donneur 10 est, dans ce cas, un substrat démontable, dont deux exemples sont illustrés sur les figures 5a et 5b. Il est formé d'une couche superficielle 12 assemblée à un support 13 via une interface de collage 11 démontable. Une telle interface 11 peut être obtenue par exemple par rugosification de la surface de la couche superficielle 12 et/ou de la surface du support 13, avant leur assemblage direct, par adhésion moléculaire. Le fait que les surfaces assemblées présentent une rugosité, typiquement entre 0,5 nm et 1 nm RMS (mesurée par AFM, sur scans de 20 microns x 20 microns), décroit l'énergie de collage de l'interface 11 et lui confère son caractère démontable.

Dans le premier exemple en figure 5a, la couche superficielle 12 du substrat donneur démontable 10 constitue la couche monocristalline 1.

Dans le deuxième exemple en figure 5b, la couche superficielle 12 comprend d'une part une couche 12a qui forme la couche cristalline 1 et d'autre part une première couche de collage 12b, qui est avantageusement en oxyde de silicium. La surface à assembler de cette première couche de collage 12b est ainsi traitée pour la rugosification, évitant à la future couche cristalline 1 de subir ce traitement. Optionnellement, une deuxième couche de collage 13b peut être disposée sur la base 13a du support 13. Elle est avantageusement de même nature que la première couche de collage 12b et facilite la réutilisation de la base 13a après séparation de la couche superficielle 12. Dans les deux exemples énoncés, la couche superficielle 12, destinée à former en tout ou partie la couche monocristalline 1, peut être obtenue à partir d'un substrat initial monocristallin, assemblé via l'interface démontable 11 au support 13, puis aminci par voie mécanique, mécanochimique et/ou chimique à des épaisseurs comprises entre quelques microns et plusieurs dizaines de microns. Pour des épaisseurs de couche superficielle 12 plus faibles, le procédé Smart Cut^{™} pourra par exemple être mis en œuvre pour transférer ladite couche superficielle 12 depuis le substrat initial sur le support 13, via l'interface démontable 11.

Selon un troisième mode de réalisation, le plan fragile enterré 11 peut être formé par une couche poreuse, par exemple en silicium poreux, ou par tout autre couche, film ou interface fragilisé autorisant une séparation ultérieure le long de ladite couche.

Dans l'un ou l'autre de ces modes de réalisation, les caractéristiques de la couche semi-conductrice monocristalline 1 sont choisies de manière à conférer à la couche les propriétés élastiques visées pour l'application. L'épaisseur de la couche cristalline 1 peut être comprise entre 0,1 micron et 100 microns. Son matériau est choisi par exemple, parmi le silicium, le carbure de silicium, etc.

Le procédé de fabrication comprend ensuite la fourniture d'un substrat receveur 3 présentant une face avant 3a et une face arrière 3b (figure 3b). Le substrat receveur 3 a avantageusement la forme d'une plaquette, de diamètre supérieur à 100mm, par exemple 150mm, 200mm ou 300mm. Son épaisseur est typiquement comprise entre 200 et 900 microns. Il est préférentiellement formé à partir de matériaux à faible coût (silicium, verre, plastique) quand sa fonction est essentiellement mécanique, ou à partir de substrats fonctionnalisés (incluant des composants tels que des transistors, par exemple) quand des dispositifs intégrés sont visés.

Dans tous les cas, le substrat receveur 3 comporte au moins une cavité 31 débouchant au niveau de sa face avant 3a. On parlera par la suite d'une cavité 31 mais le substrat receveur 3 comprend avantageusement une pluralité de cavités 31 réparties sur l'ensemble de sa face avant 3a. Une cavité 31 pourra présenter des dimensions, dans le plan (x,y) de la face avant 3a, comprises entre quelques dizaines de microns et quelques centaines de microns, et une hauteur (ou profondeur), selon l'axe z normal à la face avant 3a, de l'ordre de quelques dixièmes de microns à quelques dizaines de microns.

La cavité 31 peut être vide, c'est-à-dire dépourvue de matériau solide, ou remplie d'un matériau solide sacrificiel qui sera éliminé plus tard, dans le procédé de fabrication de la structure composite 100 ou lors de la fabrication de composants sur ladite structure composite 100.

On notera qu'il peut être plus avantageux d'avoir, à ce stade, une cavité 31 remplie pour faciliter les étapes ultérieures du procédé de fabrication. Le matériau sacrificiel disposé dans la cavité 31 peut être de l'oxyde de silicium, du nitrure de silicium, du silicium sous forme amorphe ou poly-cristalline, etc. Il est choisi en fonction de la nature du substrat receveur 3. En effet, ce matériau est destiné à être éliminé, après que la structure composite 100 soit formée : il doit donc pouvoir être gravé chimiquement avec une bonne sélectivité vis-à-vis du substrat receveur 3 et des couches élastique 1 et piézoélectrique 2 (disposées au-dessus de la cavité).

Le procédé de fabrication comprend ensuite une étape c) de formation d'une couche piézoélectrique 2. Cette couche 2 est formée sur la couche monocristalline 1 du substrat donneur 10 et/ou sur le substrat receveur 3, directement ou via une couche isolante intermédiaire 41,43.

Dans l'exemple de la figure 3c, la couche piézoélectrique 2 est disposée sur le substrat receveur 3. Alternativement, elle peut être disposée sur le substrat donneur 10. Dans ce dernier cas de figure, l'étape c) peut comprendre une gravure locale de la couche piézoélectrique 2, de manière à réaliser des motifs (« patterning ») dans le plan (x,y) de la couche 2. Cela permet de définir un (ou des) pavé(s) de couche piézoélectrique 2 destiné(s) à être en vis-à-vis d'une (ou de plusieurs) cavité(s) du substrat receveur 3, à l'issue de l'étape d) suivante. Ainsi, la couche piézoélectrique 2 à motifs n'est pas en contact avec le substrat receveur 3, bien que disposée entre la couche élastique 1 et ledit substrat receveur 3. A l'issue du procédé de fabrication, on peut alors aboutir à une structure composite 100 telle qu'illustrée sur la figure 1c.

La couche piézoélectrique 2 peut être formée par dépôt, tel que les dépôts physiques en phase vapeur (PVD), les dépôts par ablation laser (PLD), les procédés sol-gel (solution-gélification) ou les épitaxies ; on citera notamment des matériaux déposés tels que le PZT, l'AlN, le KNN, le BaTiO3, PMN-PT, le ZnO, l'AlScN, etc. La couche piézoélectrique 2 peut alternativement être formée par transfert de couche d'un substrat source vers le substrat destination (substrat donneur 10 et/ou sur substrat receveur 3). Le substrat source pourra notamment être en LiNbO3, en LiTaO3, etc. La couche piézoélectrique 2 peut être monocristalline ou poly-cristalline, selon la technique utilisée et le matériau choisi.

Selon la nature de la couche piézoélectrique 2, sa formation peut requérir des températures plus ou moins importantes. Si le substrat receveur 3 est basé sur un substrat fonctionnalisé (incluant des composants), la couche piézoélectrique 2 est avantageusement réalisée sur le substrat donneur 10. Si le substrat receveur 3 est compatible avec les températures de formation de la couche piézoélectrique 2, cette dernière pourra être élaborée indifféremment sur l'un et/ou l'autre des substrats donneur 10 et receveur 3.

Le substrat donneur 10 est bien sûr choisi, parmi les modes de mise en œuvre précités, de manière à être compatible avec les températures requises pour la formation de la couche piézoélectrique 2, lorsque celle-ci est formée sur ledit substrat 10. Ce choix se fera également en prenant en compte l'éventuelle existence d'opérations technologiques que l'on souhaiterait mettre en œuvre au niveau de la couche piézoélectrique 2 et/ou de la couche élastique 1 avant l'assemblage des substrats donneur 10 et receveur 3.

A titre d'exemple, le PZT peut être déposé à température ambiante par voie « solgel » comme cela est connu en soi, avec une épaisseur typique de quelques microns. Pour obtenir une couche piézoélectrique 2 en PZT de bonne qualité, il est ensuite nécessaire de réaliser un recuit de cristallisation à des températures de l'ordre de 700°C. Si la couche piézoélectrique 2 est formée sur le substrat donneur 10, on choisira donc préférentiellement un substrat démontable selon le deuxième mode de réalisation évoqué précédemment, qui est compatible avec des températures supérieures ou égales à 700°C. Compatible signifie ici que le substrat démontable conserve son caractère démontable même après application des températures précitées.

Selon un autre exemple, une couche d'AlN poly-cristallin peut être déposé entre 250°C et 500°C par une technique conventionnelle de dépôt par pulvérisation cathodique (« sputtering »). Un recuit de cristallisation n'est pas requis. Des substrats donneurs 10 des trois modes de réalisation énoncés précédemment sont compatibles avec un tel dépôt, ainsi qu'une grande majorité de substrats receveurs 3, même fonctionnalisés.

Le procédé de fabrication selon l'invention comprend avantageusement une étape de formation d'électrodes 21,22 métalliques, en contact avec la couche piézoélectrique 2, avant et/ou après le dépôt de cette dernière. Les électrodes 21,22 sont formées soit sur une seule face de la couche piézoélectrique 2 et se présentent avantageusement sous la forme d'un peigne interdigité, soit sur les deux faces de la couche 2 telles que deux films métalliques. On pourra notamment utiliser le platine, l'aluminium, le titane ou encore le molybdène, comme matériau pour former les électrodes 21,22.

Les électrodes 21,22 ne doivent pas être en contact direct avec la couche cristalline 1, il est donc nécessaire de prévoir une couche isolante intermédiaire 41 (figure 3c). Notons que les électrodes 21,22 ne doivent pas non plus être en contact direct avec le substrat receveur 3 lorsque ce dernier est de nature semi-conductrice ou conductrice ; dans ce cas, une couche isolante intermédiaire 43 entre la couche piézoélectrique 2 et le substrat receveur 3 est prévue.

A la suite de la formation de la couche piézoélectrique 2, le procédé de fabrication comprend une étape d'assemblage du substrat donneur 10 et du substrat receveur 3 au niveau de leurs faces avant 10a,3a respectives (figure 3d). Différents types d'assemblage sont envisageables. On pourra notamment mettre en œuvre un collage direct, par adhésion moléculaire ou un collage par thermocompression ou encore un collage polymère, avec des surfaces assemblées de nature isolante ou métallique. Une interface d'assemblage 6 est ainsi définie entre les deux substrats 10,3 qui forment, à ce stade du procédé, une structure collée.

Selon une première option illustrée sur les figures 3c et 3d, la couche piézoélectrique 2 comporte deux électrodes 21,22 interdigitées et une couche isolante 41 sur sa face libre, avant assemblage. La couche isolante 41 isole électriquement les électrodes 21,22 du substrat donneur 10 et favorise l'assemblage.

Selon une deuxième option, la couche piézoélectrique 2 comporte une première électrode 21 et une deuxième électrode 22 formées par des films métalliques respectivement disposés sur l'une et l'autre face de ladite couche 2 (comme illustré sur la figure 6). Un collage métallique mettant à profit la présence d'une électrode 22 sur une face de la couche piézoélectrique 2 pourra donc avantageusement être mis en œuvre. Le substrat donneur 10 peut alors comporter une couche de collage métallique 61 pour une mise en contact avec l'électrode 22. Une couche isolante intermédiaire 41 peut être prévue entre la couche de collage 61 et la couche monocristalline 1.

La première et la deuxième option sont illustrées avec une couche piézoélectrique 2 déposée sur le substrat receveur 3 ; notons que ces options s'appliquent de manière similaire si elle est déposée sur le substrat donneur 10.

Le procédé de fabrication selon l'invention comprend enfin une étape de séparation, le long du plan fragile enterré 11, entre la couche monocristalline 1 et le reste 10' du substrat donneur 10 (figure 3e). La structure composite 100, comprenant la couche semi-conductrice monocristalline 1 disposée sur la couche piézoélectrique 2, elle-même disposée sur le substrat receveur 3, est ainsi obtenue.

L'étape de séparation peut être réalisée de différentes manières, selon le mode de réalisation du substrat donneur 10 choisi.

En particulier, selon le premier mode de réalisation, la séparation le long du plan fragile 11 enterré est obtenue par un traitement thermique et/ou par l'application d'une contrainte mécanique, qui va(vont) provoquer une fracture dans la zone de microfissures sous pression gazeuses générée par les espèces implantées.

Selon le deuxième mode de réalisation, la séparation le long du plan fragile 11 enterré est préférentiellement obtenue par l'application d'une contrainte mécanique au niveau de l'interface démontable.

Selon le troisième mode de réalisation, l'application d'une contrainte mécanique est également privilégiée.

La contrainte mécanique peut être appliquée par insertion d'un outil en biseau, par exemple une lame en téflon, entre les bords les substrats assemblés : l'effort de traction est transmis au plan fragile enterré 11 dans lequel une onde de fracture ou de décollement s'amorce. Bien sûr, l'effort de traction s'applique également à l'interface d'assemblage 6 de la structure collée. Il est donc important de renforcer suffisamment cette interface 6, de manière à ce que la séparation s'opère au niveau du plan fragile enterré 11 et non à cette interface 6.

Des étapes de finition de la face avant 100a de la structure composite 100, correspondant à la surface libre de la couche monocristalline 1 après séparation, pourront être opérées, de manière à restaurer un bon niveau de qualité en termes de rugosité, défectivité ou nature du matériau. Cette finition peut comprendre un lissage par polissage mécanochimique, des nettoyages et/ou des gravures chimiques.

Il est possible d'élaborer un dispositif 150, basé sur une membrane 50 mobile au-dessus d'une cavité 31, à partir de la structure composite 100 obtenue. Pour cela, des ouvertures aménagées à travers la couche monocristalline 1, la couche piézoélectrique 2, et potentiellement les électrodes 21,22 et les couches isolantes intermédiaires 41,43,61, permettent de graver sélectivement le matériau remplissant la cavité 31 (si la cavité 31 est effectivement remplie à ce stade du procédé).

Des éléments fonctionnels 51, destinés à être connectés aux électrodes de la couche piézoélectrique 2 ou à interagir avec la membrane 50 peuvent être élaborés sur ou dans la couche élastique 1 (figure 3f). Ces éléments fonctionnels 51 peuvent comprendre des transistors, des diodes ou autres composants microélectroniques. La structure composite 100 est avantageuse en ce qu'elle procure une couche monocristalline 1 avec une surface libre 100a plane vierge, robuste et qui par ailleurs facilite l'éventuelle élaboration de composants de surface.

Des vias conducteurs 52, s'étendant à travers la couche élastique 1, permettent de raccorder électriquement les électrodes 21,22 aux éléments fonctionnels 51 si besoin.

### Exemples de mise en œuvre :

**Selon un premier exemple,** le substrat donneur 10 est un substrat démontable et le plan fragile enterré 11 correspond à une interface de collage rugosifiée ou faiblement stabilisée en température. Le substrat donneur 10 est de type SOI épais, avec une couche superficielle 12a en silicium monocristallin de 20 microns, sur une couche d'oxyde de silicium enterrée 12b,13b au cœur de laquelle s'étend l'interface démontable 11 (figure 5b). La couche d'oxyde de silicium 12b,13b est elle-même disposée sur un substrat support 13a en silicium.

Une couche de nucléation en oxyde de silicium est formée sur la face avant 10a du substrat donneur 10 afin de favoriser une croissance bien texturée et donc une bonne qualité des couches qui seront déposées ultérieurement (électrode métal 21,22 et couche piézoélectrique 2). Un film métallique destiné à former une première électrode 21,22, en platine, est déposé sur la couche de nucléation. Afin d'améliorer la tenue de ce film métallique sur l'oxyde de silicium, une couche intercalaire d'accroche en titane est déposée au préalable, sous le platine. Un dépôt conventionnel de type « solgel » d'une couche piézoélectrique 2 en PZT est ensuite opéré, de manière à former une épaisseur de couche de quelques microns, par exemple entre 1 et 5 microns. Un recuit de cristallisation, à une température comprise entre 650°C et 750°C environ, est ensuite appliqué au substrat donneur 10 muni de sa couche piézoélectrique 2. La deuxième électrode 21,22, en platine, est déposée sous forme d'un film métallique sur la surface libre de la couche de PZT 2.

Le substrat receveur 3 est un substrat vierge de silicium dans lequel sont gravées des cavités 31, par exemple de forme carrée, présentant des dimensions latérales de 50 microns et une profondeur de 5 microns. Les cavités 31 sont dépourvues de matériau solide. Une couche d'oxyde de silicium de 0,5 microns est déposée sur le substrat receveur 3, inclus le fond et les flancs des cavités 31.

L'assemblage entre le substrat donneur 10 et le substrat receveur 3 est opéré par collage métallique par thermocompression entre le film de l'électrode sur la face avant 10a du substrat donneur 10 et une couche métallique préalablement déposée sur la face avant 3a du substrat receveur 3, en dehors des cavités 31. Les conditions de thermocompression dépendent notamment du choix des métaux à assembler. Une température comprise entre 300°C et 500°C sera par exemple retenue dans le cas où l'or a été choisi pour la couche métallique déposée sur la face avant 3a du substrat receveur 3.

L'insertion d'une lame en téflon entre les bords des deux substrats assemblés applique une contrainte mécanique à l'interface démontable 11 ; celle-ci étant la zone la plus fragile de la structure collée, une séparation s'opère le long de ladite interface 11, menant à la formation de la structure composite 100 d'une part, et à l'obtention du reste 10' du substrat donneur 10 d'autre part.

On obtient ainsi une membrane 50 surplombant chaque cavité 31. La membrane 50 comprend la couche élastique 1 de 20 microns en silicium monocristallin et la couche piézoélectrique 2 avec ses électrodes 21,22, de quelques microns d'épaisseur.

Des étapes supplémentaires visant à isoler électriquement une pluralité de dispositifs de la structure composite 10 et à former des éléments fonctionnels pourront être ensuite implémentées.

**Dans un deuxième exemple,** les substrats donneur 10 et receveur 3 initiaux sont similaires à ceux du premier exemple. Le substrat receveur 3 comporte une couche d'oxyde de silicium sur sa face avant 3a. Cette fois, les cavités 31 sont remplies d'oxyde de silicium, matériau sacrificiel destiné à être gravé après fabrication de la structure composite 100.

Un dépôt conventionnel de type « solgel » d'une couche piézoélectrique 2 en PZT est ensuite opéré, de manière à former une épaisseur de couche de quelques microns sur le substrat receveur 3. Un recuit de cristallisation à 700°C est appliqué au substrat receveur 3 muni de sa couche piézoélectrique 2. Des électrodes 21,22 interdigitées, en platine, sont réalisées sur la surface libre de la couche en PZT 2.

Une couche isolante 41 en oxyde de silicium est déposée sur les électrodes 21,22 et la couche piézoélectrique 2, puis planarisée (par exemple par polissage mécano-chimique), de manière à favoriser l'assemblage sur le substrat donneur 10. L'assemblage entre les faces avant respectives du substrat donneur 10 et du substrat receveur 3 est opéré par collage direct oxyde/silicium par adhésion moléculaire. Un traitement thermique de consolidation de l'interface d'assemblage 6 est réalisé à une température comprise entre 600°C et 700°C.

L'insertion d'une lame en téflon entre les bords des deux substrats assemblés applique une contrainte mécanique à l'interface démontable 11 ; celle-ci étant la zone la plus fragile de la structure collée, une séparation s'opère le long de ladite interface 11, menant à la formation de la structure composite 100 d'une part, et à l'obtention du reste 10' du substrat donneur 10 d'autre part.

Le matériau sacrificiel remplissant les cavités 31 peut être gravé à ce stade ou ultérieurement, après réalisation des composants ou autres éléments fonctionnels 51 sur la couche monocristalline 1. On obtient ainsi une membrane 50 surplombant chaque cavité 31. La membrane 50 comprend la couche élastique 1 de 20 microns de silicium monocristallin et la couche piézoélectrique 2 avec ses électrodes interdigitées, de quelques microns d'épaisseur.

**Selon un troisième exemple,** le substrat donneur 10 est un substrat en silicium monocristallin et le plan fragile enterré 11 correspond à une zone implantée en ions hydrogène à une énergie de 210keV et une dose de l'ordre de 7^{e}16/cm². Une couche monocristalline 1 d'environ 1,5 micron est ainsi délimitée entre la face avant 10a du substrat donneur 10 et la zone implantée 11.

Un dépôt conventionnel par pulvérisation cathodique d'une couche piézoélectrique 2 en AlN poly-cristallin est ensuite opéré, de manière à former une épaisseur de couche entre 0,5 à 1 micron sur la face avant du substrat donneur 10, préalablement muni d'une couche isolante. Des électrodes 21,22, en molybdène, sont réalisées de chaque coté de la couche 2 en AlN.

Le substrat receveur 3 est un substrat vierge de silicium dans lequel sont gravées des cavités 31, par exemple de forme carrée, présentant des dimensions latérales de 25 microns et une profondeur de 0,3 microns. Les cavités 31 sont remplies d'oxyde de silicium, matériau sacrificiel destiné à être gravé après fabrication de la structure composite 100.

Une couche isolante en oxyde de silicium est déposée sur les électrodes 21,22 et la couche piézoélectrique 2, puis planarisée (par exemple par polissage mécano-chimique), de manière à favoriser l'assemblage sur le substrat receveur 3. L'assemblage entre les faces avant respectives du substrat donneur 10 et du substrat receveur 3 est opéré par collage direct oxyde/silicium par adhésion moléculaire. Un traitement thermique de consolidation de l'interface d'assemblage 6 est réalisé à 350°C.

La séparation le long du plan fragile enterré 11 est obtenue par l'application d'un traitement thermique à la structure collée, à une température d'environ 500°C, du fait de la croissance de microfissures sous pression dans la zone implantée jusqu'à propagation d'une onde de fracture sur toute l'étendue de ladite zone. Cette séparation mène à la formation de la structure composite 100 d'une part et à l'obtention du reste 10' du substrat donneur 10 d'autre part.

Une étape de finition par polissage mécano-chimique et nettoyage standard est appliquée à la structure composite 100, pour conférer un bon niveau de qualité et une faible rugosité à la surface libre de la couche monocristalline 1 en silicium.

Le matériau sacrificiel remplissant les cavités 31 peut être gravé à ce stade ou ultérieurement, après réalisation des composants ou autres éléments fonctionnels 51 sur la couche monocristalline 1.

On obtient une membrane 50 surplombant chaque cavité 31. La membrane 50 comprend la couche élastique 1 de 1,2 micron de silicium monocristallin et la couche piézoélectrique 2 en AlN avec ses électrodes, de moins d'un micron d'épaisseur.

Bien entendu, l'invention n'est pas limitée aux modes de réalisation et aux exemples décrits, et on peut y apporter des variantes de réalisation sans sortir du cadre de l'invention tel que défini par les revendications.

## Revendications

1. Structure composite (100) comprenant :
- un substrat receveur (3) comportant au moins une cavité (31) définie dans ledit substrat et dépourvue de matériau solide ou remplie d'un matériau solide sacrificiel,
- une couche semi-conductrice monocristalline (1) disposée sur le substrat receveur (3), ladite couche présentant une surface libre sur toute l'étendue de la structure et une épaisseur comprise entre 0,1 µm et 100 µm,
- une couche piézoélectrique (2) solidaire de la couche semi-conductrice monocristalline (1) et disposée entre cette dernière et le substrat receveur (3),
au moins une portion de la couche semi-conductrice monocristalline (1) étant destinée à former une membrane (50) mobile au-dessus de la cavité (31), lorsque cette dernière est dépourvue de matériau solide ou après que le matériau solide sacrificiel ait été éliminé, et
la couche piézoélectrique (2) étant destinée à provoquer ou détecter la déformation de ladite membrane (50).

2. Structure composite (100) selon la revendication précédente, dans laquelle la couche piézoélectrique (2) comprend un matériau choisi parmi le niobate de lithium LiNbO₃, le tantalate de lithium LiTaO₃, le niobate de potassium-sodium KₓNa₁₋ₓNbO₃ ou KNN, le titanate de barium BaTiO₃, le quartz, le titano-zirconate de plomb PZT, un composé de niobate de plomb-magnésium et de titanate de plomb PMN-PT, l'oxide de zinc ZnO, le nitrure d'aluminium AlN ou le nitrure d'aluminium et de scandium AlScN.

3. Structure composite (100) selon l'une des revendications précédentes, dans laquelle la couche piézoélectrique (2) présente une épaisseur inférieure à 10 µm, préférentiellement inférieure à 5 µm.

4. Structure composite (100) selon l'une des revendications précédentes, dans laquelle la couche semi-conductrice monocristalline (1) est en silicium ou en carbure de silicium.

5. Structure composite (100) selon l'une des revendications précédentes, dans laquelle la couche piézoélectrique (2) est disposée uniquement en vis-à-vis de la -au moins une-cavité (31) du substrat receveur (3).

6. Structure composite (100) selon l'une des revendications 1 à 4, dans laquelle la couche piézoélectrique (2) est disposée en vis-à-vis de la -au moins une- cavité (31) du substrat receveur (3) et est solidaire du substrat receveur (3) en dehors de la -au moins une- cavité (31).

7. Dispositif (150) basé sur une membrane (50) mobile au-dessus d'une cavité (31), formé à partir de la structure composite (100) selon l'une des revendications précédentes, comprenant au moins deux électrodes (21,22) en contact avec la couche piézoélectrique (2), et dans lequel :
- la cavité (31) est dépourvue de matériau solide,
- et au moins une portion de la couche semi-conductrice monocristalline (1) forme la membrane (50) mobile au-dessus de la cavité (31).

8. Procédé de fabrication d'une structure composite (100) selon l'une des revendications 1 à 6, comprenant les étapes suivantes :
a) la fourniture d'un substrat donneur (10) comprenant une couche semi-conductrice monocristalline (1), délimitée entre une face avant (10a) du substrat donneur (10) et un plan fragile enterré (11) dans ledit substrat donneur (10), ladite couche (1) présentant une épaisseur comprise entre 0,1 µm et 100 µm,
b) la fourniture d'un substrat receveur (3) comportant au moins une cavité (31) définie dans ledit substrat et débouchant au niveau d'une face avant (3a) du substrat receveur (3), la cavité (31) étant dépourvue de matériau solide ou remplie d'un matériau solide sacrificiel,
c) la formation d'une couche piézoélectrique (2) de manière à ce qu'elle soit disposée sur la face avant (10a) du substrat donneur (10) et/ou sur la face avant (3a) du substrat receveur (3),
d) l'assemblage du substrat donneur (10) et du substrat receveur (3) au niveau de leurs faces avant respectives,
e) la séparation, le long du plan fragile enterré (11), entre la couche semi-conductrice monocristalline (1) et le reste (11') du substrat donneur, pour former la structure composite (100) comprenant la couche semi-conductrice monocristalline (1), la couche piézoélectrique (2) et le substrat receveur (3).

9. Procédé de fabrication selon la revendication précédente, dans lequel le plan fragile enterré (11) est formé par implantation d'espèces légères dans le substrat donneur (10), et la séparation le long du plan fragile enterré (11) est obtenue par un traitement thermique et/ou par l'application d'une contrainte mécanique.

10. Procédé de fabrication selon la revendication 8, dans lequel le plan fragile enterré (11) est formé par une interface présentant une énergie de collage inférieure à 0,7 J/m².

11. Procédé de fabrication selon l'une des trois revendications précédentes, comprenant une étape de formation d'électrodes métalliques (21,22) avant et/ou après l'étape c), pour que lesdites électrodes soient en contact avec la couche piézoélectrique (2).

12. Procédé de fabrication selon l'une des quatre revendications précédentes, dans lequel l'étape c) comprend, lorsque la couche piézoélectrique (2) est formée sur la face avant (10a) du substrat donneur (10), une gravure locale de ladite couche piézoélectrique (2), de manière à conserver la couche piézoélectrique (2) uniquement en vis-à-vis de la -au moins une- cavité (31) à l'issue de l'étape d) d'assemblage.

## Patentansprüche

1. Verbundstruktur (100), umfassend:
- ein Empfängersubstrat (3), das mindestens einen Hohlraum (31) aufweist, der in dem Substrat definiert ist und frei von festem Material ist oder mit einem festen Opfermaterial gefüllt ist,
- eine einkristalline Halbleiterschicht (1), die auf dem Empfängersubstrat (3) angeordnet ist, wobei die Schicht eine freie Oberfläche über die gesamte Ausdehnung der Struktur und eine Dicke zwischen 0,1 µm und 100 µm vorweist,
- eine piezoelektrische Schicht (2), die mit der einkristallinen Halbleiterschicht (1) fest verbunden und zwischen dieser letzteren und dem Empfängersubstrat (3) angeordnet ist,
wobei mindestens ein Abschnitt der einkristallinen Halbleiterschicht (1) dazu bestimmt ist, eine bewegliche Membran (50) über dem Hohlraum (31) auszubilden, wenn dieser letztere frei von festem Material ist oder nachdem das feste Opfermaterial entfernt worden ist, und
wobei die piezoelektrische Schicht (2) dazu bestimmt ist, die Verformung der Membran (50) zu bewirken oder zu erfassen.

2. Verbundstruktur (100) nach dem vorstehenden Anspruch, wobei die piezoelektrische Schicht (2) ein Material umfasst, das aus Lithiumniobat LiNbO₃, Lithiumtantalat LiTaO₃, Kalium-Natrium-Niobat KₓNa₁₋ₓNbO₃ oder KNN, Bariumtitanat BaTiO₃, Quarz, Blei-Zirkonat-Titanat PZT, einer Blei-Magnesium-Niobat-Blei-Titanat-Verbindung PMN-PT, Zinkoxid ZnO, Aluminiumnitrid AlN oder Aluminium-Scandium-Nitrid AlScN ausgewählt ist.

3. Verbundstruktur (100) nach einem der vorstehenden Ansprüche, wobei die piezoelektrische Schicht (2) eine Dicke von weniger als 10 µm, vorzugsweise von weniger als 5 µm, vorweist.

4. Verbundstruktur (100) nach einem der vorstehenden Ansprüche, wobei die einkristalline Halbleiterschicht (1) aus Silizium oder Siliziumkarbid besteht.

5. Verbundstruktur (100) nach einem der vorstehenden Ansprüche, wobei die piezoelektrische Schicht (2) ausschließlich gegenüber des -mindestens einen-Hohlraums (31) des Empfängersubstrats (3) angeordnet ist.

6. Verbundstruktur (100) nach einem der Ansprüche 1 bis 4, wobei die piezoelektrische Schicht (2) gegenüber des -mindestens einen- Hohlraums (31) des Empfängersubstrats (3) angeordnet ist und außerhalb des -mindestens einen-Hohlraums (31) mit dem Empfängersubstrat (3) fest verbunden ist.

7. Vorrichtung (150) basierend auf einer beweglichen Membran (50) über einem Hohlraum (31), die aus der Verbundstruktur (100) nach einem der vorstehenden Ansprüche ausgebildet ist, umfassend mindestens zwei Elektroden (21, 22) in Kontakt mit der piezoelektrischen Schicht (2), und wobei:
- der Hohlraum (31) frei von festem Material ist,
- und mindestens ein Teil der einkristallinen Halbleiterschicht (1) die bewegliche Membran (50) über dem Hohlraum (31) ausbildet.

8. Verfahren zum Herstellen einer Verbundstruktur (100) nach einem der Ansprüche 1 bis 6, umfassend die folgenden Schritte:
a) Bereitstellen eines Donorsubstrats (10), umfassend eine einkristalline Halbleiterschicht (1), die zwischen einer Vorderseite (10a) des Donorsubstrats (10) und einer in der Erde verlegten Schwächeebene (11) in dem Donorsubstrat (10) begrenzt ist, wobei die Schicht (1) eine Dicke aufweist, die zwischen 0,1 µm und 100 µm liegt,
b) Bereitstellen eines Empfängersubstrats (3), das mindestens einen Hohlraum (31) aufweist, der in dem Substrat definiert ist und an einer Vorderseite (3a) des Empfängersubstrats (3) mündet, wobei der Hohlraum (31) frei von festem Material ist oder mit einem festen Opfermaterial gefüllt ist,
c) Ausbilden einer piezoelektrischen Schicht (2) derart, dass sie auf der Vorderseite (10a) des Donorsubstrats (10) und/oder auf der Vorderseite (3a) des Empfängersubstrats (3) angeordnet ist,
d) Zusammenfügen des Donorsubstrats (10) und des Empfängersubstrats (3) an ihren jeweiligen Vorderseiten,
e) Trennen entlang der in der Erde verlegten Schwächeebene (11) zwischen der einkristallinen Halbleiterschicht (1) und dem Rest (11') des Donorsubstrats, um die Verbundstruktur (100) auszubilden, die die einkristalline Halbleiterschicht (1), die piezoelektrische Schicht (2) und das Empfängersubstrat (3) umfasst.

9. Herstellungsverfahren nach dem vorstehenden Anspruch, wobei die in der Erde verlegte Schwächeebene (11) durch Implantation von leichten Spezies in das Donorsubstrat (10) ausgebildet wird und das Trennen entlang der in der Erde verlegten Schwächeebene (11) durch eine Wärmebehandlung und/oder durch das Aufbringen einer mechanischen Spannung erzielt wird.

10. Herstellungsverfahren nach Anspruch 8, wobei die in der Erde verlegte Schwächeebene (11) durch eine Grenzfläche ausgebildet wird, die eine Haftenergie von weniger als 0,7 J/m² aufweist.

11. Herstellungsverfahren nach einem der drei vorstehenden Ansprüche, umfassend einen Schritt zum Ausbilden von Metallelektroden (21, 22) vor und/oder nach dem Schritt c), so dass die Elektroden mit der piezoelektrischen Schicht (2) in Kontakt stehen.

12. Herstellungsverfahren nach einem der vier vorstehenden Ansprüche, wobei der Schritt c), wenn die piezoelektrische Schicht (2) auf der Vorderseite (10a) des Donorsubstrats (10) ausgebildet wird, ein lokales Ätzen der piezoelektrischen Schicht (2) umfasst, so dass die piezoelektrische Schicht (2) nach Abschluss des Schritts d) des Zusammenfügens nur gegenüber des - mindestens einen- Hohlraums (31) erhalten bleibt.

## Claims

1. Composite structure (100) comprising:
- a receiver substrate (3) comprising at least one cavity (31) defined in said substrate and being without solid material or being filled with a sacrificial solid material,
- a monocrystalline semi-conductor layer (1) arranged on the receiver substrate (3), said layer having a free surface across the full extent of the structure and having a thickness between 0.1 µm and 100 µm,
- a piezoelectric layer (2) rigidly connected to the monocrystalline semi-conductor layer (1) and arranged between the latter and the receiver substrate (3),
at least a portion of the monocrystalline semi-conductor layer (1) being intended to form a movable membrane (50) above the cavity (31) when the latter is without solid material or after the sacrificial solid material has been removed, and
the piezoelectric layer (2) being intended to cause or detect the deformation of said membrane (50).

2. Composite structure (100) according to the preceding claim, wherein the piezoelectric layer (2) comprises a material selected from lithium niobate LiNbO₃, lithium tantalate LiTaO₃, potassium sodium niobate KₓNa₁₋ₓNbO₃ or KNN, barium titanate BaTiO₃, quartz, lead titanate zirconate PZT, a lead magnesium niobate and lead titanate compound PMN-PT, zinc oxide ZnO, aluminum nitride AlN, or aluminum scandium nitride AlScN.

3. Composite structure (100) according to either of the preceding claims, wherein the piezoelectric layer (2) has a thickness of less than 10 µm, preferably less than 5 µm.

4. Composite structure (100) according to any of the preceding claims, wherein the monocrystalline semi-conductor layer (1) is made of silicon or silicon carbide.

5. Composite structure (100) according to any of the preceding claims, wherein the piezoelectric layer (2) is only arranged opposite the -at least one-cavity (31) of the receiver substrate (3).

6. Composite structure (100) according to any of claims 1 to 4, wherein the piezoelectric layer (2) is arranged opposite the -at least one- cavity (31) of the receiver substrate (3) and is rigidly connected to the receiver substrate (3) outside the -at least one- cavity (31).

7. Device (150) based on a movable membrane (50) above a cavity (31) and made from the composite structure (100) according to any of the preceding claims, comprising at least two electrodes (21, 22) in contact with the piezoelectric layer (2), and wherein:
- the cavity (31) is without solid material,
- and at least a portion of the monocrystalline semi-conductor layer (1) forms the movable membrane (50) above the cavity (31).

8. Method for manufacturing a composite structure (100) according to any of claims 1 to 6, comprising the following steps:
a) providing a donor substrate (10) comprising a monocrystalline semi-conductor layer (1) delimited between a front face (10a) of the donor substrate (10) and a buried brittle plane (11) in said donor substrate (10), said layer (1) having a thickness between 0.1 µm and 100 µm,
b) providing a receiver substrate (3) comprising at least one cavity (31) defined in said substrate and opening at a front face (3a) of the receiver substrate (3), the cavity (31) being without solid material or being filled with a sacrificial solid material,
c) forming a piezoelectric layer (2) such that it is arranged on the front face (10a) of the donor substrate (10) and/or on the front face (3a) of the receiver substrate (3),
d) joining the donor substrate (10) and the receiver substrate (3) at the respective front faces thereof,
e) separating, along the buried brittle plane (11), between the monocrystalline semi-conductor layer (1) and the remainder (11') of the donor substrate, to form the composite structure (100) comprising the monocrystalline semi-conductor layer (1), the piezoelectric layer (2), and the receiver substrate (3).

9. Manufacturing method according to the preceding claim, wherein the buried brittle plane (11) is formed by implanting light species into the donor substrate (10), and the separating along the buried brittle plane (11) is achieved by heat treatment and/or by applying a mechanical stress.

10. Manufacturing method according to claim 8, wherein the buried brittle plane (11) is formed by an interface having a bonding energy of less than 0.7 J/m².

11. Manufacturing method according to any of the three preceding claims, comprising a step of forming metal electrodes (21, 22) before and/or after step c), so that said electrodes are in contact with the piezoelectric layer (2).

12. Manufacturing method according to any of the four preceding claims, wherein step c) comprises, when the piezoelectric layer (2) is formed on the front face (10a) of the donor substrate (10), a local etching of said piezoelectric layer (2), so as to only preserve the piezoelectric layer (2) opposite the -at least one-cavity (31) at the end of step d) of joining.
